(19) **Europäisches Patentamt / European Patent Office / Office européen des brevets**

(11) **EP 3 829 089 A1**

(12) # EUROPEAN PATENT APPLICATION
published in accordance with Art. 153(4) EPC

(43) Date of publication:
**02.06.2021 Bulletin 2021/22**

(21) Application number: **19842121.6**

(22) Date of filing: **03.07.2019**

(51) Int Cl.:
**H04L 1/00** $^{(2006.01)}$

(86) International application number:
**PCT/CN2019/094508**

(87) International publication number:
**WO 2020/019954 (30.01.2020 Gazette 2020/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
**KH MA MD TN**

(30) Priority: **24.07.2018  CN 201810821527**

(71) Applicant: **ZTE Corporation**
**shenzhen Guangdong  518057 (CN)**

(72) Inventors:
• **WEI, Hao**
  **Shenzhen, Guangdong 518057 (CN)**
• **GAO, Jie**
  **Shenzhen, Guangdong 518057 (CN)**
• **LI, Jie**
  **Shenzhen, Guangdong 518057 (CN)**
• **REN, Zhen**
  **Shenzhen, Guangdong 518057 (CN)**

(74) Representative: **Iannone, Carlo Luigi et al**
**Barzanò & Zanardo Milano S.p.A.**
**Via Borgonuovo, 10**
**20121 Milano (IT)**

(54) **METHOD AND DEVICE FOR DECODING POLAR CODE, STORAGE MEDIUM, AND ELECTRONIC DEVICE**

(57)    Provided are a method and apparatus for decoding a polar code, a storage medium, and an electronic apparatus. The method includes: determining first positions of a polarization sequence for placing information bits included in the polar code; determining first information bits included in the information bits according to a reliability of the first positions, where a reliability of first positions used for placing the first information bits in the polarization sequence is lower than a reliability of first positions used for placing information bits other than the first information bits among the information bits; and performing path expansion on the first information bits to decode the polar code.

```
                                                              S102
┌────────────────────────────────────────────────┐
│ Determine first positions of a polarization     │
│ sequence for placing information bits included   │
│ in a polar code                                  │
└────────────────────────────────────────────────┘
                         │
                         ▼
                                                              S104
┌────────────────────────────────────────────────┐
│ Determine first information bits included in the │
│ information bits according to a reliability of   │
│ the first positions                              │
└────────────────────────────────────────────────┘
                         │
                         ▼
                                                              S106
┌────────────────────────────────────────────────┐
│ Perform a path expansion on the first            │
│ information bits to decode the polar code        │
└────────────────────────────────────────────────┘
```

**FIG. 1**

EP 3 829 089 A1

**Description**

This application claims priority to Chinese Patent Application No. 201810821527.9 filed with the CNIPA on July 24, 2018, the disclosure of which is incorporated herein by reference in its entirety.

TECHNICAL FIELD

The present application relates to the field of communications, for example, to a method and apparatus for decoding a polar code, a storage medium, and an electronic apparatus.

BACKGROUND

The polar code is a channel coding scheme based on channel polarization and digital signal processing technologies. The channel polarization introduces correlation through channel division and channel combination operations on a binary memoryless channel, so as to obtain a new group of binary polarized channels with interdependency. When the number of channels participating in the channel polarization is large enough, the polarization phenomenon may exist in the channel capacities of the obtained polarized channels (or bit channels), that is, capacities of some channels tend to be 1 while capacities of the remaining channels tend to be 0. With this polarization phenomenon, free bits may be carried on bit channels with high channel capacities, and fixed bits (or frozen bits) may be carried on bit channels with low channel capacities, thereby improving the transmission reliability.

Currently, most polar codes in the related art are decoded using a decoding scheme based on a successive cancellation list decoding algorithm. When the above decoding scheme is used for decoding, multiple paths need to be decoded concurrently by means of the path expansion. Although the above decoding scheme can ensure the decoding performance, a decoding delay increases sharply when the polar codes are decoded. Therefore, the usage of the conventional decoding scheme of the polar code is limited in a communication scenario with a relatively high delay requirement.

In the related art, no solution has been proposed for the problem in the related art of a too-large delay in the case of decoding the polar code.

SUMMARY

The present invention provides a method and apparatus for decoding a polar code, a storage medium, and an electronic apparatus, to solve at least the problem in the related art of a too-large delay when the polar code is decoded.

An embodiment of the present application provides a method for decoding a polar code. The method includes steps described below, first positions in a polarization sequence which are used for placing information bits included in the polar code are determined; first information bits included in the information bits are determined according to a reliability of the first positions, where a reliability of first position used for placing the first information bits in the polarization sequence is lower than a reliability of first positions used for placing information bits other than the first information bits among the information bits; and a path expansion is performed on the first information bits to decode the polar code.

Another embodiment of the present application provides an apparatus for decoding a polar code. The apparatus includes a first determination module, a second determination module, and a decoding module. The first determination module is configured to determine first positions in a polarization sequence which are used for placing information bits included in the polar code. The second determination module is configured to determine first information bits included in the information bits according to a reliability of the first positions, where a reliability of first positions used for placing the first information bits in the polarization sequence is lower than a reliability of first positions used for placing information bits other than the first information bits among the information bits. The decoding module is configured to perform a path expansion on the first information bits to decode the polar code.

Another embodiment of the present application further provides a storage medium, which is configured to store a computer program, the computer program is configured to, when executed, perform steps in any one of the method embodiments described above.

Another embodiment of the present application further provides an electronic apparatus including a memory and a processor, the memory is configured to store a computer program, and the processor is configured to execute the computer program to perform steps in any one of the method embodiments described above.

BRIEF DESCRIPTION OF DRAWINGS

The drawings described herein are used to provide a further understanding of the present application and form a part of the present application. The illustrative embodiments and descriptions thereof in the present application are used to explain the present application and not to limit the present application in any improper way. In the drawings:

FIG. 1 is a flowchart of a method for decoding a polar code according to an embodiment of the present invention;

FIG. 2 is a diagram of performance simulation of a BLER according to application embodiment one of the present invention;

FIG. 3 is a diagram of performance simulation of a BLER according to application embodiment two of the present invention;

FIG. 4 is a block diagram of an apparatus for decoding a polar code according to an embodiment of the present invention; and

FIG. 5 is a block diagram of an apparatus for decoding a polar code according to an exemplary embodiment of the present invention.

DETAILED DESCRIPTION

Hereinafter, the present application will be described in detail with reference to drawings and in conjunction with embodiments. It is to be noted that if not in collision, the embodiments and features therein in the present application may be combined with each other.

It is to be noted that the terms such as "first" and "second" in the description, claims and drawings of the present application are used to distinguish between similar objects and are not necessarily used to describe a particular order or sequence.

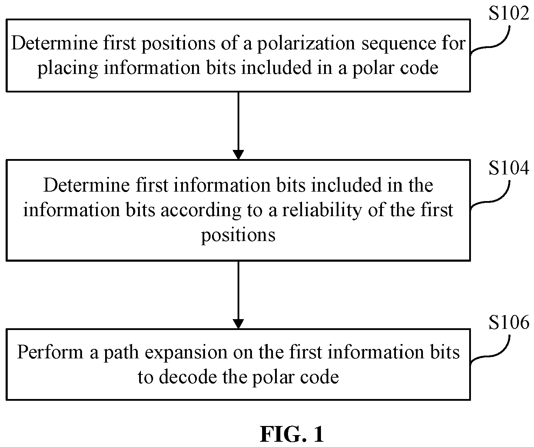

An embodiment of the present application provides a method for decoding a polar code. FIG. 1 is a flowchart of a method for decoding a polar code according to an embodiment of the present invention. As shown in FIG. 1, the process of the method includes steps S102, S104, and S106.

In step S102, first positions in a polarization sequence which are used for placing information bits included in the polar code are determined.

In step S104, first information bits included in the information bits are determined according to a reliability of the first positions.

A reliability of first positions used for placing the first information bits in the polarization sequence is lower than a reliability of first positions used for placing information bits other than the first information bits among the information bits.

In step S106, a path expansion is performed on the first information bits to decode the polar code.

With the preceding steps, the first information bits at the first positions having the reliability lower than the reliability of first positions where the remaining information bits are located may be determined among the information bits according to the reliability of the first positions in the polarization sequence which are used for placing the information bits included in the polar code, and the path expansion is performed on the first information bits to decode the polar code. Therefore, the preceding steps can solve the problem in the related art of a too-large delay when the polar code is decoded, thereby reducing the delay when the polar code is decoded.

In an embodiment, when the polar code is decoded through the preceding steps, a decoding manner in the related art where the path expansion is directly performed on all information bits is avoided so that the object of the path expansion is limited to the first information bits. The part of the information bits other than the first information bits may be considered as reliable information bits, and for the reliable information bits, a direct decision may be adopted when the polar code is decoded. Therefore, the number of information bits subjected to the path expansion is reduced in the processing process of the preceding steps, so that the storage complexity and the ordering computation complexity of decoding paths in a decoding process are reduced, thereby reducing the delay when the polar code is decoded.

In addition, with the preceding steps, on the premise of reducing the delay when the polar code is decoded, the decoding performance and decoding delay requirements can be balanced and adjusted.

In an embodiment, the preceding steps may, but may not necessarily, be performed by a controller, a coder, a decoder, or the like.

In step S102, the polarization sequence is a matrix sequence including multiple bit positions used for placing different types of bits included in the polar code. The bits included in the polar code include information bits and frozen bits, where the information bits are used for carrying and transmitting information and the frozen bits are used for calibration or verification function. The positions used for placing the information bits in the polarization sequence are the first positions, and positions used for placing the frozen bits may be fixed positions.

In an embodiment, assuming that a codeword length of the polar code is N, N is a positive integer which is a power of 2 due to the property of the polar code. The number of bit positions in the polarization sequence is determined by the codeword length of the polar code. For example, when the codeword length of the polar code is N, the corresponding polarization sequence is $Q_0^{N-1} = \{Q_0^N, Q_1^N, Q_2^N, ..., Q_{N-1}^N\}$, where $0 \leq Q_i^N \leq N-1$, $Q_i^N$ denotes a bit serial number before the polar code is coded, and $i = 0,1,..., N-1$.

In step S104, the reliability of the first positions used for placing the first information bits in the polarization sequence is lower than the reliability of the first positions used for placing the information bits other than the first information bits among the information bits, which refers to an overall comparison relationship. In an embodiment, a maximum value of reliabilities of the first positions used for placing the first information bits in the polarization sequence is smaller than a minimum value of reliabilities of the first positions used for placing the information bits other than the first information bits among the information bits, that is, the reliability of the first positions for placing the first information bits determined among the information bits belongs to a lower side in the first positions for placing all the information bits.

In addition, after the first information bits among the information bits are determined, a manner where the first information bits are identified in a bitmap may be adopted, so as to identify the first information bits, which is only an optional manner. The reliability of the first positions may refer to, for example, the reliability of decoding channels corresponding to the first positions at the time of decoding.

In step S106, the path expansion is performed on the first information bits to decode the polar code, which only includes that a decoding manner for the first information bits when the polar code is decoded includes the path expansion. The path extension may refer to, for example, generating two decoding paths to respectively decode information bits "0" and "1" at corresponding first positions.

In an embodiment, assuming that L decoding paths need to be decoded through the path expansion, after the path expansion is completed, path metrics (PM) of expanded decoding paths are calculated and ordered, and L decoding paths are reserved. The preceding operations are repeatedly performed until the decoding is completed and a decoding result is outputted.

In this embodiment, the first information bits at the first positions having the reliability lower than the reliability of first positions where the remaining information bits are located may be determined among the information bits according to the reliability of the first positions in the polarization sequence which are used for placing the information bits included in the polar code, and the path expansion is performed on the first information bits to decode the polar code. Similarly, information bits at first positions having a relatively high reliability are selected from the information bits and the path expansion is not performed on these information bits, which is a technical solution equivalent to that in this embodiment.

In an embodiment, before step S104 in which the first information bits included in the information bits are determined according to the reliability of the first positions is performed, the method further includes a step described below.

A number of the first information bits included in the information bits is determined according to a number of bits included in the polar code, a number of the information bits included in the polar code, and a tolerance error, where the tolerance error is used for indicating decoding performance in the case of decoding the polar code.

In an embodiment, the information bits at the first positions having the relatively high reliability among the information bits, that is, the reliable information bits, may be determined according to the number of bits included in the polar code, the number of the information bits included in the polar code, and the tolerance error. The first information bits are information bits at first positions having a lower reliability than the reliability of the reliable information bits. The reliable information bits and the first information bits constitute all the information bits together, there is no intersection between the first information bits and the reliable information bits, and the information bits include no information bit other than the first information bits and the reliable information bits. Based on the obtained reliable information bits, the part of the information bits other than the reliable information bits are all the first information bits. Therefore, the number of the first information bits may be determined according to the number of the information bits included in the polar code and the number of the reliable information bits.

Meanwhile, the tolerance error is used for indicating the decoding performance when the polar code is decoded. In an embodiment, the tolerance error may be represented by an increase of a block error rate (BLER) when a signal-to-noise ratio (SNR) is given in the decoding process or an increase of the SNR when the BLER is given in the decoding process. It is to be noted that the tolerance error is not limited to the preceding two parameters, and any parameter that can indicate the decoding performance when the polar code is decoded may be used as the tolerance error.

In an embodiment, the tolerance error is determined by at least one of decoding channel quality in the case of decoding the polar code or a decoding delay in the case of decoding the polar code.

In an embodiment, step S104 in which the first information bits included in the information bits are determined according to the reliability of the first positions further includes a step described below.

The first information bits included in the information bits are determined according to the reliability of the first positions and the number of the first information bits.

In an embodiment, the first information bits are the information bits at the first position with the higher reliability among the information bits. Therefore, when the specific number of the first information bits among the information bits is determined, the specific first information bits among the information bits may be determined by ordering reliabilities of the first positions or selecting a number of leading positions from the first positions that have been ordered according to the reliabilities.

In an embodiment, before step S102 in which the first positions of the polarization sequence used for placing the information bits included in the polar code are determined, the method further includes a step described below.

A length of the polarization sequence is determined according to the number of bits included in the polar code and the number of the information bits.

In an embodiment, the length of the polarization sequence is the number of bit positions included in the polarization sequence, and the number of bits included in the polar code may be the same as the codeword length of the polar code or may be different from the codeword length of the polar code.

In an actual operation, the bits actually included in the polar code may differ from the codeword length of the polar code. Assuming that the polar code includes E bits, it may be obtained according to standards related to the polar code that the codeword length of the polar code is N. According to the sizes of E and N, the polarization sequence in which the corresponding bits are placed may be obtained through operations such as repetitions and puncturing. A transmission code rate R of the polar code is that $R = K / E$.

In an embodiment, step S102 in which the first positions in the polarization sequence which are used for placing the information bits included in the polar code are determined includes a step described below.

The first positions in the polarization sequence which are used for placing the information bits included in the polar code are determined according to a reliability of each position of the polarization sequence, where the reliability of the first positions is greater than a reliability of remaining positions in the polarization sequence.

In an embodiment, as assumed above, when the codeword length of the polar code is N, the corresponding polarization sequence is $Q_0^{N-1} = \left\{ Q_0^N, Q_1^N, Q_2^N, ..., Q_{N-1}^N \right\}$, where $0 \le Q_i^N \le N-1$, $Q_i^N$ denotes the bit serial number before the polar code is coded, and $i = 0, 1, ..., N$-1. In step S102, the first positions in the polarization sequence which are used for placing the information bits included in the polar code are determined according to the reliability of each position of the polarization sequence so that elements in the polarization sequence $Q_0^{N-1}$ that are arranged in ascending order according to the reliability $W\left( Q_i^N \right)$ of the bit serial number $Q_i^N$ may satisfy that:

$$W\left( Q_0^N \right) < W\left( Q_1^N \right) < ... < W\left( Q_{N-1}^N \right).$$ On the premise that the preceding positions in the polarization sequence are determined, the corresponding positions having the relatively high reliability in the polarization sequence may be selected according to the number of the information bits as the first positions to place the information bits.

Meanwhile, for the frozen bits other than the information bits in the polar code, the frozen bits may be placed at remaining positions other than the first positions in the polarization sequence, that is, corresponding positions having a relatively low reliability in the polarization sequence, which may be referred to as the fixed positions.

In an embodiment, the step in which the path expansion is performed on the first information bits to decode the polar code further includes a step described below.

A direct decision is performed on bits other than the first information bits among the bits included in the polar code.

In an embodiment, the bits included in the polar code include the frozen bits and some information bits other than the first information bits, where the some information bits are the part of the information bits other than the first information bits, that is, the reliable information bits. The direct decision performed on the frozen bits and reliable bits can avoid the path expansion on all the information bits in the related art, thereby reducing the delay when the polar code is decoded. It is to be noted that the direct decision refers to that the reliable information bits are directly decided to be "0" or "1" according to corresponding information (which includes a logarithmic likelihood ratio obtained after channels corresponding to the first information bits are subjected to the signal demodulation in the decoding process) in the decoding process without being processed through the path expansion. The frozen bits are certainly "0" and thus do not need to be subjected to the path expansion.

From the description of the preceding embodiment, it will be apparent to those skilled in the art that the method in the preceding embodiment may be implemented by software plus a necessary general-purpose hardware platform or may of course be implemented by hardware. However, in many cases, the former is a preferred implementation. Based on this understanding, the technical solution provided by the present application substantially, or the part contributing to the related art, may be embodied in the form of a software product. The computer software product is stored on a storage medium (such as a read-only memory (ROM)/random-access memory (RAM), a magnetic disk, or an optical disk) and includes several instructions for enabling a terminal device (which may be a mobile phone, a computer, a server, or a network device) to perform the method according to the embodiments of the present application.

To further describe the content of the preceding embodiment, embodiment one is specifically described through application embodiments.

Application embodiment one

Assuming that the number E of bits actually included in the polar code is 64 and the number K of information bits among the E bits is 18, exemplary steps of decoding the polar code are steps S202 to S208.

In step S202, according to the decoding channel quality when the polar code is decoded, the decoding delay when the polar code is decoded, and the decoding performance when the polar code is decoded, a control module determines the tolerance error $\delta$ used for indicating the decoding performance, where $\delta = 0.2$ dB , and the tolerance error here is used for indicating that an SNR difference does not exceed 0.2 dB in a case where at an operating point BLER = $10^{-2}$.

In step S204, a decoding module calculates a codeword length N of the polar code according to the number of bits included in the polar code and the number of information bits to be 64, that is, there are 64 positions in total in the corresponding polarization sequence, orders reliabilities of all positions in the polarization sequence, and places the information bits and frozen bits in the polar code into the polarization sequence according to the reliabilities of all positions. The obtained polarization sequence is shown in Table 1.

Table 1

| $W\left(Q_i^N\right)$ | $Q_i^N$ | $W\left(Q_i^N\right)$ | $Q_i^N$ | $W\left(Q_i^N\right)$ | $Q_i^N$ | $W\left(Q_i^N\right)$ | $Q_i^N$ |
|---|---|---|---|---|---|---|---|
| 0 | 0 | 16 | 20 | 32 | 22 | 48 | 30 |
| 1 | 1 | 17 | 34 | 33 | 38 | 49 | 45 |
| 2 | 2 | 18 | 24 | 34 | 41 | 50 | 51 |
| 3 | 4 | 19 | 36 | 35 | 28 | 51 | 46 |
| 4 | 8 | 20 | 7 | 36 | 42 | 52 | 53 |
| 5 | 16 | 21 | 11 | 37 | 49 | 53 | 54 |
| 6 | 32 | 22 | 40 | 38 | 44 | 54 | 57 |
| 7 | 3 | 23 | 19 | 39 | 50 | 55 | 58 |
| 8 | 5 | 24 | 13 | 40 | 15 | 56 | 60 |
| 9 | 9 | 25 | 48 | 41 | 52 | 57 | 31 |
| 10 | 6 | 26 | 14 | 42 | 23 | 58 | 47 |
| 11 | 17 | 27 | 21 | 43 | 56 | 59 | 55 |
| 12 | 10 | 28 | 35 | 44 | 27 | 60 | 59 |
| 13 | 18 | 29 | 26 | 45 | 39 | 61 | 61 |
| 14 | 12 | 30 | 37 | 46 | 29 | 62 | 62 |
| 15 | 33 | 31 | 25 | 47 | 43 | 63 | 63 |

In the preceding polarization sequence, $Q_i^N$ denotes a serial number of a bit position in the polarization sequence before coding is performed, and $W\left(Q_i^N\right)$ denotes a reliability corresponding to the bit position. As can be seen from the above table, bit positions in the polarization sequence are reordered according to the reliabilities, for example, in ascending order of the reliabilities. Therefore, positions for placing the 18 information bits in the polar code are [29, 43, 30, 45, 51, 46, 53, 54, 57, 58, 60, 31, 47, 55, 59, 61, 62, 63].

In step S206, it can be seen according to the number E of bits actually included in the polar code, the number K of information bits, and the tolerance error $\delta$, where E = 64, K = 18, and $\delta = 0.2$ dB , that the number of information bits which may serve as the reliable information bits among the information bits is determined as 10, 10 information bits [57, 58, 60, 31, 47, 55, 59, 61, 62, 63] placed at positions having higher reliabilities are selected from the information bits, and the 10 reliable information bits are used as the reliable information bits, and the 10 reliable information bits are identified in a bitmap. Correspondingly, the remaining eight information bits [29, 43, 30, 45, 51, 46, 53, 54] among the information bits are the first information bits.

In step S208, decoding of the polar code is performed on the above decoding sequence. At the time of decoding, only the eight information bits [29, 43, 30, 45, 51, 46, 53, 54] are subjected to the path expansion, and the reliable information bits are subjected to the direct decision.

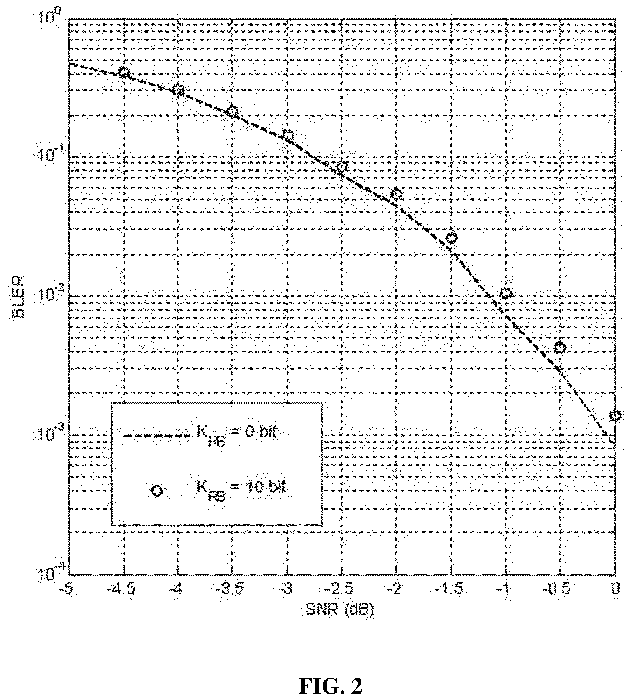

At the time of decoding, the quadrature phase-shift keying (QPSK) is used for regulation and control processing, and the polar code is decoded based on the successive cancellation list (SCL) decoding algorithm. During the decoding process, the performance simulation result of the BLER is shown in FIG. 2. As shown in FIG. 2, in a case where at the operating point BLER = 10$^{-2}$, the number $K_{RB}$ of reliable information bits satisfies that $K_{RB}$ = 10, so that the SNR difference can be smaller than 0.2 dB and the decoding delay can be effectively reduced at the same time.

Application embodiment two

Assuming that the number E of bits actually included in a polar code is 144 and the number K of information bits among the E bits is 48, exemplary steps of decoding the polar code are steps S302 to S308.

In step S302, according to the decoding channel quality when the polar code is decoded, the decoding delay when the polar code is decoded, and the decoding performance when the polar code is decoded, a control module determines the tolerance error $\delta$ used for indicating the decoding performance, where $\delta$ = 0.01dB, and the tolerance error here is used for indicating that an SNR difference does not exceed 0.01 dB in a case where at the operating point BLER = 10$^{-2}$.

In step S304, a decoding module calculates a codeword length N of the polar code according to the number of bits included in the polar code and the number of information bits to be 128, that is, there are 128 positions in total in the corresponding polarization sequence, orders reliabilities of the positions in the polarization sequence, and places the information bits and frozen bits in the polar code into the polarization sequence according to the reliabilities of the positions. The obtained polarization sequence is shown in Table 2.

Table 2

| $W\left(Q_i^N\right)$ | $Q_i^N$ | $W\left(Q_i^N\right)$ | $Q_i^N$ | $W\left(Q_i^N\right)$ | $Q_i^N$ | $W\left(Q_i^N\right)$ | $Q_i^N$ |
|---|---|---|---|---|---|---|---|
| 0 | 0 | 32 | 21 | 64 | 43 | 96 | 55 |
| 1 | 1 | 33 | 35 | 65 | 98 | 97 | 113 |
| 2 | 2 | 34 | 26 | 66 | 88 | 98 | 79 |
| 3 | 4 | 35 | 80 | 67 | 30 | 99 | 108 |
| 4 | 8 | 36 | 37 | 68 | 71 | 100 | 59 |
| 5 | 16 | 37 | 25 | 69 | 45 | 101 | 114 |
| 6 | 32 | 38 | 22 | 70 | 100 | 102 | 87 |
| 7 | 3 | 39 | 38 | 71 | 51 | 103 | 116 |
| 8 | 5 | 40 | 96 | 72 | 46 | 104 | 61 |
| 9 | 64 | 41 | 67 | 73 | 75 | 105 | 91 |
| 10 | 9 | 42 | 41 | 74 | 104 | 106 | 120 |
| 11 | 6 | 43 | 28 | 75 | 53 | 107 | 62 |
| 12 | 17 | 44 | 69 | 76 | 77 | 108 | 103 |
| 13 | 10 | 45 | 42 | 77 | 54 | 109 | 93 |
| 14 | 18 | 46 | 49 | 78 | 83 | 110 | 107 |
| 15 | 12 | 47 | 74 | 79 | 57 | 111 | 94 |
| 16 | 33 | 48 | 70 | 80 | 112 | 112 | 109 |
| 17 | 65 | 49 | 44 | 81 | 78 | 113 | 115 |
| 18 | 20 | 50 | 81 | 82 | 85 | 114 | 110 |

(continued)

| $W\left(Q_i^N\right)$ | $Q_i^N$ | $W\left(Q_i^N\right)$ | $Q_i^N$ | $W\left(Q_i^N\right)$ | $Q_i^N$ | $W\left(Q_i^N\right)$ | $Q_i^N$ |
|---|---|---|---|---|---|---|---|
| 19 | 34 | 51 | 50 | 83 | 58 | 115 | 117 |
| 20 | 24 | 52 | 73 | 84 | 99 | 116 | 118 |
| 21 | 36 | 53 | 15 | 85 | 86 | 117 | 121 |
| 22 | 7 | 54 | 52 | 86 | 60 | 118 | 122 |
| 23 | 66 | 55 | 23 | 87 | 89 | 119 | 63 |
| 24 | 11 | 56 | 76 | 88 | 101 | 120 | 124 |
| 25 | 40 | 57 | 82 | 89 | 31 | 121 | 95 |
| 26 | 68 | 58 | 56 | 90 | 90 | 122 | 111 |
| 27 | 19 | 59 | 27 | 91 | 102 | 123 | 119 |
| 28 | 13 | 60 | 97 | 92 | 105 | 124 | 123 |
| 29 | 48 | 61 | 39 | 93 | 92 | 125 | 125 |
| 30 | 14 | 62 | 84 | 94 | 47 | 126 | 126 |
| 31 | 72 | 63 | 29 | 95 | 106 | 127 | 127 |

In the preceding polarization sequence, $Q_i^N$ denotes a serial number of a bit position in the polarization sequence before coding is performed, and $W\left(Q_i^N\right)$ denotes a reliability corresponding to the bit position. As can be seen from the above table, bit positions in the polarization sequence are reordered according to the reliabilities, for example, in ascending order of the reliabilities. Therefore, the positions for placing the 48 information bits in the polar code are [112, 78, 85, 58, 99, 86, 60, 89, 101, 31, 90, 102, 105, 92, 47, 106, 55, 113, 79, 108, 59, 114, 87, 116, 61, 91, 120, 62, 103, 93, 107, 94, 109, 115, 110, 117, 118, 121, 122, 63, 124, 95, 111, 119, 123, 125, 126, 127].

In step S306, it can be seen according to the number E of bits actually included in the polar code, the number K of information bits, and the tolerance error $\delta$, where E = 144, K = 48, and $\delta$ = 0.01dB, that the number of information bits which may serve as the reliable information bits among the information bits is 26, 26 information bits [87, 116, 61, 91, 120, 62, 103, 93, 107, 94, 109, 115, 110, 117, 118, 121, 122, 63, 124, 95, 111, 119, 123, 125, 126, 127] placed at positions with relatively high reliabilities are selected from the information bits, these 26 reliable information bits are used as the reliable information bits, and the 26 reliable information bits are identified in a bitmap. Correspondingly, remaining 22 information bits [112, 78, 85, 58, 99, 86, 60, 89, 101, 31, 90, 102, 105, 92, 47, 106, 55, 113, 79, 108, 59, 114] among the information bits are the first information bits.

In step S308, the decoding of the polar code is performed on the above decoding sequence. At the time of decoding, only the 22 information bits [112, 78, 85, 58, 99, 86, 60, 89, 101, 31, 90, 102, 105, 92, 47, 106, 55, 113, 79, 108, 59, 114] are subjected to the path expansion, and the reliable information bits are subjected to the direct decision.

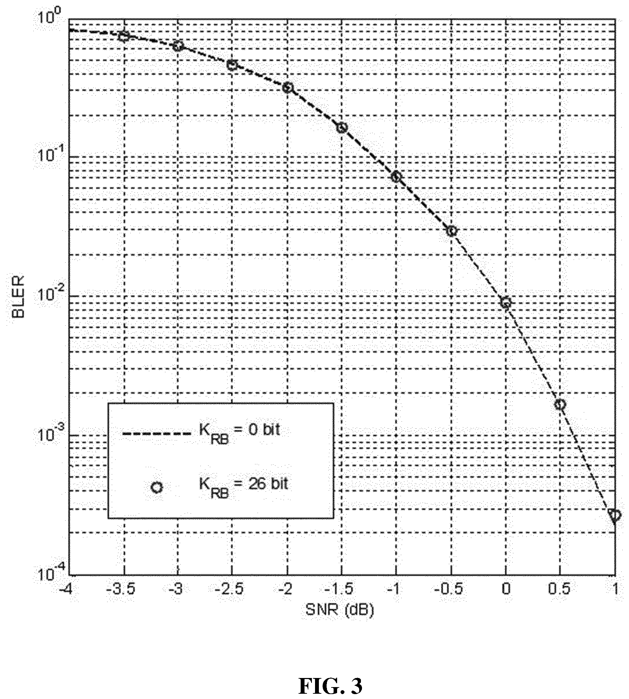

At the time of decoding, the quadrature phase-shift keying (QPSK) is used for regulation and control, and the polar code is decoded based on the successive cancellation list (SCL) decoding algorithm. During the decoding process, the performance simulation result of the BLER is shown in FIG. 3. As shown in FIG. 3, in the case where at the operating point BLER = $10^{-2}$, the number $K_{RB}$ of reliable information bits satisfies that $K_{RB}$ = 26 , so that the SNR difference can be smaller than 0.01 dB and the decoding delay can be effectively reduced at the same time.

An exemplary embodiment of the present application further provides an apparatus for decoding a polar code. The apparatus is used for implementing the above-mentioned embodiments and application embodiments. What has been described will not be repeated here. As used below, the term "module" may be software, hardware, or a combination thereof capable of implementing predetermined functions. The apparatus in the embodiment described below is preferably implemented by software, but the implementation by hardware or by a combination of software and hardware is also possible and conceivable.

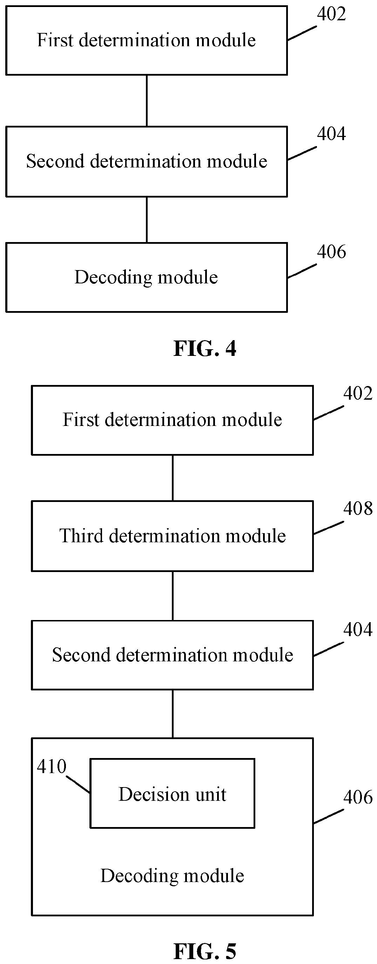

FIG. 4 is a block diagram of an apparatus for decoding a polar code according to an embodiment of the present invention. As shown in FIG. 4, the apparatus includes a first determination module 402, a second determination module 404, and a decoding module 406.

The first determination module 402 is configured to determine first positions in a polarization sequence which are used for placing information bits included in the polar code.

The second determination module 404 is configured to determine first information bits included in the information bits according to a reliability of the first positions, where a reliability of first positions used for placing the first information bits in the polarization sequence is lower than a reliability of first positions used for placing information bits other than the first information bits among the information bits.

The decoding module 406 is configured to perform a path expansion on the first information bits to decode the polar code.

With the above apparatus, the first information bits at the first position having the reliability lower than the reliability of the first positions where remaining information bits are located may be determined among the information bits according to the reliability of the first positions in the polarization sequence which are used for placing the information bits included in the polar code, and the path expansion is performed on the first information bits to decode the polar code. Therefore, the above steps can solve the problem in the related art of a too-large delay when the polar code is decoded, thereby reducing the delay when the polar code is decoded.

FIG. 5 is a block diagram of an apparatus for decoding a polar code according to an exemplary embodiment of the present invention. As shown in FIG. 5, the apparatus further includes a third determination module 408 and a decision unit 410 in addition to all modules shown in FIG. 4.

The third determination module 408 is configured to determine the number of the first information bits included in the information bits according to a number of bits included in the polar code, a number of the information bits included in the polar code, and a tolerance error, where the tolerance error is used for indicating decoding performance in a case of decoding the polar code.

The decision unit 410 is configured to perform a direct decision on bits other than the first information bits among the bits included in the polar code. The decision unit 410 is disposed in the decoding module 406.

It is to be noted that the various modules described above may be implemented by software or hardware. An implementation by hardware may, but may not necessarily, be performed in the following manners: the various modules described above are located in the same processor, or the various modules described above are located in their respective processors in any combination form.

An exemplary embodiment of the present application further provides a storage medium. The storage medium is configured to store a computer program, where when the computer program is executed, steps in any one of the method embodiments described above are performed.

In an embodiment, the storage medium may be configured to store a computer program for performing steps S1 to S3.

In step S1, first positions in a polarization sequence which are used for placing information bits included in a polar code are determined.

In step S2, first information bits included in the information bits are determined according to a reliability of the first positions, where a reliability of first position used for placing the first information bits in the polarization sequence is lower than a reliability of first positions used for placing information bits other than the first information bits among the information bits.

In step S3, a path expansion is performed on the first information bits so that the polar code is decoded.

In an embodiment, the storage medium is further configured to store a program code for performing step S4.

In step S4, a number of the first information bits included in the information bits is determined according to a number of bits included in the polar code, a number of the information bits included in the polar code, and a tolerance error, where the tolerance error is used for indicating decoding performance in a case of decoding the polar code.

In an embodiment, the storage medium is further configured to store a program code for performing step S5.

In step S5, a direct decision is performed on bits other than the first information bits among the bits included in the polar code so that the polar code is decoded.

In an embodiment, the storage medium may include, but is not limited to, a USB flash disk, a read-only memory (ROM), a random-access memory (RAM), a mobile hard disk, a magnetic disk, an optical disk or another medium capable of storing computer programs.

An exemplary embodiment of the present application further provides an electronic apparatus including a memory and a processor, where the memory is configured to store a computer program, and the processor is configured to execute the computer program to perform steps in any one of the method embodiments described above.

In an embodiment, the electronic apparatus may further include a transmission device and an input/output device. The transmission device is connected to the processor. The input/output device is connected to the processor.

In an embodiment, the processor may be configured to perform steps S1 to S3 through the computer program.

In step S1, first positions in a polarization sequence which are used for placing information bits included in a polar code are determined.

In step S2, first information bits included in the information bits are determined according to a reliability of the first positions, where a reliability of first positions used for placing the first information bits in the polarization sequence is lower than a reliability of first positions used for placing information bits other than the first information bits among the information bits.

In step S3, a path expansion is performed on the first information bits so that the polar code is decoded.

In an embodiment, the processor may be further configured to perform step S4 through the computer program.

In step S4, a number of the first information bits included in the information bits is determined according to a number of bits included in the polar code, a number of the information bits included in the polar code, and a tolerance error, where the tolerance error is used for indicating decoding performance in a case of decoding the polar code.

In an embodiment, the processor may be further configured to perform step S5 through the computer program.

In step S5, a direct decision is performed on bits other than the first information bits among the bits included in the polar code so that the polar code is decoded.

In an embodiment, for specific examples in this embodiment, reference may be made to the examples described in the preceding embodiments and optional implementations, and details are not described in this embodiment.

Apparently, it is to be understood by those skilled in the art that the various modules or steps of the present application may be implemented by a general-purpose computing apparatus and may be concentrated on a single computing apparatus or distributed on a network composed of multiple computing apparatuses. Alternatively, the various modules or steps may be implemented by program codes executable by the computing apparatus. Thus, these modules or steps may be stored in a storage apparatus and executed by the computing apparatus. Moreover, in some cases, the illustrated or described steps may be executed in sequences different from those described herein. Alternatively, these modules or steps may be made into integrated circuit modules separately or multiple modules or steps therein may be made into a single integrated circuit module for implementation. In this manner, the present application is not limited to any particular combination of hardware and software.

**Claims**

1. A method for decoding a polar code, comprising:

    determining first positions in a polarization sequence which are used for placing information bits contained in the polar code;
    determining first information bits contained in the information bits according to a reliability of the first positions;
    wherein a reliability of first positions used for placing the first information bits in the polarization sequence is lower than a reliability of first positions used for placing information bits other than the first information bits among the information bits; and
    performing a path expansion on the first information bits to decode the polar code.

2. The method of claim 1, before determining the first information bits contained in the information bits according to the reliability of the first positions, further comprising:
    determining a number of the first information bits contained in the information bits according to a number of bits contained in the polar code, a number of the information bits contained in the polar code, and a tolerance error;
    wherein the tolerance error is used for indicating decoding performance in a case of decoding the polar code.

3. The method of claim 2, wherein the tolerance error is determined by at least one of decoding channel quality in the case of decoding the polar code or a decoding delay in the case of decoding the polar code.

4. The method of claim 2 or 3, wherein determining the first information bits contained in the information bits according to the reliability of the first positions comprises:
    determining the first information bits contained in the information bits according to the reliability of the first positions and the number of the first information bits.

5. The method of claim 1, before determining the first positions in the polarization sequence which are used for placing the information bits contained in the polar code, further comprising:
    determining a length of the polarization sequence according to a number of bits contained in the polar code and a number of the information bits.

6. The method of claim 1 or 5, wherein determining the first positions in the polarization sequence which are used for placing the information bits contained in the polar code comprises:
    determining the first positions in the polarization sequence which are used for placing the information bits contained in the polar code according to a reliability of each position in the polarization sequence, wherein the reliability of the first positions is greater than a reliability of remaining positions other than the first positions in the polarization sequence.

7. The method of claim 1, wherein performing the path expansion on the first information bits to decode the polar code further comprises:
performing a direct decision on bits other than the first information bits among bits contained in the polar code.

8. An apparatus for decoding a polar code, comprising:

a first determination module, which is configured to determine first positions in a polarization sequence which are used for placing information bits contained in the polar code;
a second determination module, which is configured to determine first information bits contained in the information bits according to a reliability of the first positions, wherein a reliability of first positions used for placing the first information bits in the polarization sequence is lower than a reliability of first positions used for placing information bits other than the first information bits among the information bits; and
a decoding module, which is configured to perform a path expansion on the first information bits to decode the polar code.

9. A storage medium, which is configured to store a computer program, wherein the computer program is configured to, when executed, perform the method of any one of claims 1 to 7.

10. An electronic apparatus, comprising a memory and a processor, wherein the memory is configured to store a computer program, and the processor is configured to execute the computer program to perform the method of any one of claims 1 to 7.

Determine first positions of a polarization sequence for placing information bits included in a polar code

S102

Determine first information bits included in the information bits according to a reliability of the first positions

S104

Perform a path expansion on the first information bits to decode the polar code

S106

**FIG. 1**

**FIG. 2**

**FIG. 3**

First determination module — 402

Second determination module — 404

Decoding module — 406

**FIG. 4**

First determination module — 402

Third determination module — 408

Second determination module — 404

410 — Decision unit

406

Decoding module

**FIG. 5**

## INTERNATIONAL SEARCH REPORT

| | International application No. |
|---|---|
| | **PCT/CN2019/094508** |

**A. CLASSIFICATION OF SUBJECT MATTER**

H04L 1/00(2006.01)i

According to International Patent Classification (IPC) or to both national classification and IPC

**B. FIELDS SEARCHED**

Minimum documentation searched (classification system followed by classification symbols)

H04L H04W

Documentation searched other than minimum documentation to the extent that such documents are included in the fields searched

Electronic data base consulted during the international search (name of data base and, where practicable, search terms used)

CNPAT, CNKI, WPI, EPODOC: 可靠度, 可信, 可靠, 极化码, 信息比特, polar, 信息, 比特, 弱, 低, 差, 译码, 避免, 部分, 分段, 局部, 区, 非全部, 所有, 段, 延时, 判决, 直接判决, 路径扩展, low, reliability, part, section ,information, bad, bit, delay, decode, code, prevent, judge

**C. DOCUMENTS CONSIDERED TO BE RELEVANT**

| Category* | Citation of document, with indication, where appropriate, of the relevant passages | Relevant to claim No. |
|---|---|---|
| X | CN 106803759 A (NANJING UNIVERSITY OF POSTS AND TELECOMMUNICATIONS) 06 June 2017 (2017-06-06) description, paragraphs [0008]-[0027] | 1-10 |
| A | CN 107819545 A (HUAWEI TECHNOLOGIES CO., LTD.) 20 March 2018 (2018-03-20) entire document | 1-10 |
| A | CN 107612560 A (SHANDONG UNIVERSITY OF SCIENCE AND TECHNOLOGY) 19 January 2018 (2018-01-19) entire document | 1-10 |
| A | CN 103281166 A (BEIJING UNIVERSITY OF POSTS AND TELECOMMUNICATIONS) 04 September 2013 (2013-09-04) entire document | 1-10 |
| A | CN 108288969 A (HUAWEI TECHNOLOGIES CO., LTD.) 17 July 2018 (2018-07-17) entire document | 1-10 |
| A | US 2009175377 A1 (MATSUSHITA ELECTRIC INDUSTRIAL CO., LTD.) 09 July 2009 (2009-07-09) entire document | 1-10 |

☐ Further documents are listed in the continuation of Box C.       ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **13 August 2019** | **02 September 2019** |

| Name and mailing address of the ISA/CN | Authorized officer |
|---|---|
| **China National Intellectual Property Administration (ISA/CN)** **No. 6, Xitucheng Road, Jimenqiao Haidian District, Beijing 100088** **China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2019/094508**

| Patent document cited in search report | | | Publication date (day/month/year) | Patent family member(s) | | | Publication date (day/month/year) |
|---|---|---|---|---|---|---|---|
| CN | 106803759 | A | 06 June 2017 | None | | | |
| CN | 107819545 | A | 20 March 2018 | US | 2019207720 | A1 | 04 July 2019 |
| | | | | EP | 3499761 | A1 | 19 June 2019 |
| | | | | WO | 2018045849 | A1 | 15 March 2018 |
| CN | 107612560 | A | 19 January 2018 | None | | | |
| CN | 103281166 | A | 04 September 2013 | None | | | |
| CN | 108288969 | A | 17 July 2018 | WO | 2018127140 | A1 | 12 July 2018 |
| US | 2009175377 | A1 | 09 July 2009 | WO | 2006054660 | A1 | 26 May 2006 |
| | | | | KR | 20070084151 | A | 24 August 2007 |
| | | | | CN | 101065941 | A | 31 October 2007 |
| | | | | EP | 1804453 | A1 | 04 July 2007 |
| | | | | JP | 2006148676 | A | 08 June 2006 |

Form PCT/ISA/210 (patent family annex) (January 2015)

**REFERENCES CITED IN THE DESCRIPTION**

**Patent documents cited in the description**

- CN 201810821527